# EUROPEAN PATENT APPLICATION

(11) **EP 4 564 543 A1**
(43) Date of publication of application: **04.06.2025**
(21) Application number: 23212795.1
(22) Date of filing: 28.11.2023
(51) Int. Cl.: H01M 50/124, H01M 50/131, H01M 50/119, H01M 10/42, H01M 10/48

(54) **TEMPERATURE-SENSITIVE HOUSING FOR A BATTERY CELL**

(71) Applicant: Samsung SDI Co., Ltd., Yongin-si, Gyeonggi-do 17084 (KR)
(72) Inventor: Ipek, Eymen, 8020 Graz (AT)
(74) Representative: Gulde & Partner

(57) **Abstract**

The present disclosure refers to a temperature-sensitive housing for a battery cell. The present disclosure is further related to a battery module having several battery cells accommodated in the temperature-sensitive housing according to the present disclosure. Also, the disclosure is related to a battery system using the battery module, the battery system allowing for an accurate monitoring of the temperature state of the battery cells. Moreover, the present disclosure relates to a method for detecting a thermal event occurring in a battery cell equipped with a temperature-sensitive housing.

## Description

### Field of the Disclosure

The present disclosure relates to a temperature-sensitive housing for a battery cell. The present disclosure is further related to a battery module having several battery cells accommodated in the temperature-sensitive housing according to the present disclosure. Also, the disclosure is related to a battery system using the battery module, the battery system allowing for an accurate monitoring of the temperature state of the battery cells. Moreover, the present disclosure relates to a method for detecting a thermal event occurring in a battery cell equipped with a temperature-sensitive housing.

### Technological Background

Recently, vehicles for transportation of goods and peoples have been developed that use electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator or a hydrogen fuel power cell. A hybrid vehicle may include a combination of an electric motor and conventional combustion engine. Generally, an electric-vehicle battery (EVB, or traction battery) is a battery used to power the propulsion of battery electric vehicles (BEVs). Electric-vehicle batteries differ from starting, lighting, and ignition batteries in that they are designed to provide power for sustained periods of time. A rechargeable (or secondary) battery differs from a primary battery in that it is designed to be repeatedly charged and discharged, while the latter is designed to provide only an irreversible conversion of chemical to electrical energy. Low-capacity rechargeable batteries are used as power supplies for small electronic devices, such as cellular phones, notebook computers and camcorders, while high-capacity rechargeable batteries are used as power supplies for electric and hybrid vehicles and the like.

Generally, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case to enable charging and discharging of the battery via an electrochemical reaction of the positive electrode, the negative electrode, and the electrolyte solution. The shape of the case such as cylindrical or rectangular, may be selected based on the battery's intended purpose. Lithium-ion (and similar lithium polymer) batteries, widely known via their use in laptops and consumer electronics, dominate the most recent electric vehicles in development.

Rechargeable batteries may be used as a battery module formed of a plurality of battery cells coupled to each other in series and/or in parallel to provide a high energy density, such as for motor driving of a hybrid vehicle. For example, the battery module may be formed by interconnecting the electrode terminals of the plurality of unit battery cells in an arrangement or configuration depending on a desired amount of power and in order to realize a high-power rechargeable battery.

Battery modules can be constructed in either a block design or a modular design. In the block design each battery is coupled to a common current collector structure and a common battery management system and the unit thereof is arranged in a housing. In the modular design, pluralities of battery cells are connected together to form submodules and several submodules are connected together to form the battery module. In automotive applications, battery systems generally include a plurality of battery modules connected in series for providing a desired voltage. The battery modules may include submodules with a plurality of stacked battery cells and each stack includes cells connected in parallel that are, in turn, connected in series (*XpYs*) or cells connected in series that are, in turn, connected in parallel (*XsYp*).

A battery pack is a set of any number of (usually identical) battery modules. The battery modules may be configured in series, parallel or a mixture of both to deliver the desired voltage, capacity, and/or power density. Components of a battery pack include the individual battery modules and the interconnects, which provide electrical conductivity between the battery modules.

A battery system may also include a battery management system (BMS), which is any suitable electronic system that is configured to manage the rechargeable battery, battery module, and battery pack, such as by protecting the batteries from operating outside their safe operating area, monitoring their states, calculating secondary data, reporting that data, controlling its environment, authenticating it and/or balancing it. For example, the BMS may monitor the state of the battery as represented by voltage (e. g., a total voltage of the battery pack or battery modules and/or voltages of individual cells), temperature (e. g., an average temperature of the battery pack or battery modules, coolant intake temperature, coolant output temperature, and/or temperatures of individual cells), coolant flow (e. g., flow rate and/or cooling liquid pressure), and current. Additionally, the BMS may calculate values based on the above parameters, such as minimum and maximum cell voltage, state of charge (SOC) or depth of discharge (DOD) to indicate the charge level of the battery, state of health (SOH; a variously-defined measurement of the remaining capacity of the battery as % of the original capacity), state of power (SOP; the amount of power available for a defined time interval given the current power usage, temperature and other conditions), state of safety (SOS), maximum charge current as a charge current limit (CCL), maximum discharge current as a discharge current limit (DCL), and internal impedance of a cell (to determine open circuit voltage).

The BMS may be centralized such that a single controller is connected to the battery cells through a multitude of wires. In other examples, the BMS may be distributed, with a BMS board is installed at each cell, with just a single communication cable between the battery and a controller. In yet other examples, the BMS may have a modular construction including a few controllers, each handling a certain number of cells, while communicating between the controllers. Centralized BMSs are most economical, but are least expandable and are plagued by a multitude of wires. Distributed BMSs are the most expensive but are simplest to install and offer the cleanest assembly. Modular BMSs provide a compromise of the features and problems of the other two topologies.

A BMS may protect the battery pack from operating outside its safe operating area. Operation outside the safe operating area may be indicated by over-current, over-voltage (during charging), over-temperature, under-temperature, over-pressure, and ground fault or leakage current detection. The BMS may prevent the battery from operating outside its safe operating parameter area by including an internal switch (e. g., a relay or solid-state device) that opens if the battery is operated outside its safe operating parameter area, requesting the devices to which the battery is connected to reduce or even terminate using the battery, and actively controlling the environment, such as through heaters, fans, air conditioning or liquid cooling.

Static control of battery power output and charging may not be sufficient to meet the dynamic power demands of various electrical consumers connected to the battery system. Thus, steady exchange of information between the battery system and the controllers of the electrical consumers may be employed. This information may include the battery system's actual state of charge (SoC), potential electrical performance, charging ability and internal resistance as well as actual or predicted power demands or surpluses of the consumers. Therefore, battery systems usually include a battery management system (BMS), for obtaining and processing such information on a system level and may also include a plurality of battery module managers (BMMs), which are part of the system's battery modules and obtain and process relevant information on a module level. The BMS usually measures the system voltage, the system current, the local temperature at different places inside the system housing, and the insulation resistance between live components and the system housing while the BMMs usually measure the individual cell voltages and temperatures of the battery cells in a battery module.

The BMS/BMU is provided to manage the battery pack, such as by protecting the battery from operating outside its safe operating area (or safe operating parameters), monitoring its state, calculating secondary data, reporting that data, controlling its environment, authenticating it and/or balancing it.

In case of an abnormal operation state (or in the event of an abnormal condition), a battery pack should be disconnected from a load connected to a terminal of the battery pack. Therefore, battery systems may include a battery disconnect unit (BDU), that is electrically connected between the battery module and battery system terminals. The BDU is the primary interface between the battery pack and the electrical system of the vehicle. The BDU includes electromechanical switches that open or close high current paths between the battery pack and the electrical system. The BDU provides feedback to the battery control unit (BCU), accompanied to the battery modules such as voltage and current measurements. The BCU controls the switches in the BDU by using low current paths based on the feedback received from the BDU. The primary functions of the BDU may include controlling current flow between the battery pack and the electrical system and current sensing. The BDU may further manage additional functions such as external charging and pre-charging.

An active or passive thermal management system may be included to provide thermal control of the battery pack to safely use the at least one battery module by efficiently emitting, discharging, and/or dissipating heat generated from its rechargeable batteries. If the heat emission/discharge/dissipation is not sufficiently performed, temperature deviations may occur between respective battery cells, such that the at least one battery module may no longer generate a desired (or designed) amount of power. In addition, an increase of the internal temperature can lead to abnormal reactions occurring therein and thus charging and discharging performance of the rechargeable battery deteriorates, and the lifespan of the rechargeable battery is shortened.

Exothermic decomposition of cell components may lead to a so-called thermal runaway. Generally, thermal runaway describes a process that accelerates due to increased temperature, in turn releasing energy that further increases temperature. Thermal runaway occurs in situations when an increase in temperature changes the conditions in a way that causes a further increase in temperature, often leading to a destructive result. In rechargeable battery systems, thermal runaway is associated with strong exothermic reactions that are accelerated by temperature rise. These exothermic reactions include combustion of flammable gas compositions within the battery pack housing. For example, when a cell is heated above a critical temperature (for example, above 150°C), the cell can transition into a thermal runaway. The initial heating may be caused by a local failure, such as a cell internal short circuit, heating from a defective electrical contact, a short circuit to a neighboring cell, etc. During the thermal runaway, a failed battery cell, (e. g., a battery cell that has a local failure) may reach a temperature exceeding 700°C. Further, large quantities of hot gas are ejected from inside of the failed battery cell through the venting opening of the cell housing into the battery pack. The main components of the vented gas are H₂, CO₂, CO, electrolyte vapor and other hydrocarbons. The vented gas is therefore flammable and potentially toxic. The vented gas also causes a gas-pressure to increase inside the battery pack.

As described before, automotive battery systems have battery cells that can be hazardous in case of a failure. Thus, passengers need to be warned before any danger occurs outside of the battery. Fast detection of cell failures is important.

Therefore, there is a need for a means and a method that allow for an accurate monitoring of the temperature states of the battery cells used in a battery module battery system, for example, if the latter are configured to be used in fully electric or hybrid vehicles. Further, there is a need for a means and a method that allow for giving a fast alert in case of a series thermal event such as a thermal run-away occurring in one or more of the battery cells. Also, monitoring the temperature of battery cells is important to manage battery lifetime.

It is thus an object of the present disclosure to provide a means and a method that allow for an accurate monitoring of the temperature states of battery cells used in a battery module. Further, it is an object of the present disclosure to provide a means and a method that allow for giving a fast alert in case of a series thermal event such as a thermal run-away occurring in one or more of the battery cells.

### Summary of Invention

The invention is defined by the appended claims. The description that follows is subjected to this limitation. Any disclosure lying outside the scope of said claims is only intended for illustrative as well as comparative purposes.

According to a first aspect of the present disclosure, a temperature-sensitive housing for a battery cell is provided, the temperature-sensitive housing includes: a case having an outer surface; and a coating, wherein the coating at least partially covers the outer surface of the case; and wherein the coating includes a temperature-sensitive material having a temperature-dependent electrical resistance.

According to a second aspect of the present disclosure, a battery module is provided, the battery module includes: at least one battery cell, wherein at least one of the battery cells includes a temperature-sensitive housing according to an embodiment of the first aspect.

A third aspect of the present disclosure refers to battery system including: at least one battery module according to the second aspect of the disclosure; and an evaluation unit configured for: receiving a signal from each of the means for measuring an electrical resistance, the signal(s) indicating a resistance measured by the respective means for measuring an electrical resistance; detecting a deviance of each of the signals received from a means for measuring an electrical resistance from a predefined setpoint value assigned to the respective means for measuring an electrical resistance; and generating an alert signal upon detecting a deviance with an absolute value exceeding a predefined threshold.

A fourth aspect of the present disclosure relates to a vehicle including at least one temperature-sensitive housing according to the first aspect, and/or at least one battery module according to the second aspect, and/or at least one battery system according to the third aspect.

A fifth aspect of the present disclosure deals with a method for detecting a thermal event occurring in a battery cell equipped with a temperature-sensitive housing according to an embodiment of the first aspect, the method including the following steps:
a) providing a first electric conduit and a second electric conduit, each of which being electrically connected, at different positions, to the temperature-sensitive material of the temperature-sensitive housing;
b) measuring, by a means for measuring an electrical resistance, an electrical resistance between the first electric conduit and the second electric conduit;
c) creating, by the means for measuring an electrical resistance, a signal indicating the measured electrical resistance;
d) transferring the signal to an evaluation unit;
e) evaluating, by the evaluation unit and based on the signal, a deviation of the measured resistance and a predefined setpoint value;
f) generating an alert signal upon detecting a deviation having an absolute value exceeding a predefined threshold.

Further aspects of the present disclosure could be learned from the dependent claims or the following description.

### Brief Description of the Drawings

Features will become apparent to those of ordinary skill in the art by describing in detail exemplary embodiments with reference to the attached drawings in which:
- Fig. 1: is a perspective view illustrating a typical design of a battery cell according to the state-of-the-art.
- Fig. 2: is a schematic longitudinal cut through an embodiment of a battery cell housing according to an embodiment of the invention.
- Fig. 3: provides a schematic perspective view of a battery cell housing according to another embodiment of the invention.
- Fig. 4: provides a schematic side view of a battery cell housing according to still another embodiment of the invention.
- Fig. 5: is a cross-sectional image showing the microstructure of an example of a coating that can be used in embodiments of a case of a housing according to an embodiment of the invention (based on an image taken from Ref. [1]).
- Fig. 6: is a diagram illustrating the dependency of the electric resistance of a TiO₂/Cr₂O₃ layer on the average temperature T_{average} of the TiO₂/Cr₂O₃ layer (based on an image taken from Ref. [1]).
- Figs. 7A to 7C: illustrate various embodiments of a battery module according to an aspect of the present disclosure.

### Detailed Description of the invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

It will also be understood that when a film, a region, or an element is referred to as being "above" or "on" another film, region, or element, it can be directly on the other film, region, or element, or intervening films, regions, or elements may also be present.

Herein, the terms "upper" and "lower" are defined according to the z-axis. For example, the upper cover is positioned at the upper part of the z-axis, whereas the lower cover is positioned at the lower part thereof. In the drawings, the sizes of elements may be exaggerated for clarity. For example, in the drawings, the size or thickness of each element may be arbitrarily shown for illustrative purposes, and thus the embodiments of the present disclosure should not be construed as being limited thereto.

In the following description of embodiments of the present disclosure, the terms of a singular form may include plural forms unless the context clearly indicates otherwise.

The electronic or electric devices and/or any other relevant devices or components according to embodiments of the present disclosure described herein may be implemented utilizing any suitable hardware, firmware (e. g. an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e. g. on a PCB or another kind of circuit carrier. The conducting elements may comprise metallization, e. g. surface metallizations and/or pins, and/or may comprise conductive polymers or ceramics. Further electrical energy might be transmitted via wireless connections, e.g. using electromagnetic radiation and/or light.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

### General Concept

The housing for a battery cell can be structured in a way that the resistance of the housing is changing with the temperature of the battery cell accommodated in the housing. This can improve the accuracy of temperature measurement of cells.

Measuring and/or monitoring the temperature of battery cells-in embodiments even the temperature of individual battery cells-is important to manage battery lifetime. Besides, fast thermal runaway detection can be done if the individual cell temperature is known. If a battery cell housing material can act like a positive/negative temperature coefficient resistor, this can be detected by using battery management system.

According to a first aspect of the present disclosure, a temperature-sensitive housing for a battery cell is provided, the temperature-sensitive housing including: a case having an outer surface; and a coating, wherein the coating at least partially covers the outer surface of the case; and wherein the coating includes a temperature-sensitive material having a temperature-dependent electrical resistance.

Here, the term "temperature-sensitive housing" is used here simply as an easy-to-understand expression to distinguish the housing according to the first aspect of the invention from common housings. Alternatively, the housing according to the first aspect could be simply referred to as "housing" or "housing according to the invention."

Further, the term "temperature-sensitive material" is used here simply as an easy-to-understand expression to distinguish a material with a temperature-dependent measurable characteristic-here: the electrical resistance-from other materials. Alternatively, a term such as "first material" or "special material" could have been used instead of "temperature-sensitive material," the "first material" or "special material" then being defined here as a material with a temperature-dependent electrical resistance.

The quintessence of the first aspect of the present disclosure may be summarized as follows.

The battery cell housing is structured by using a temperature-dependent resistive material. Hence, the housing provides at least the following advantage: When the housing is connected to an (external) signal conditioning circuit, the signal conditioning circuit can detect a change in the temperature of the battery cell housing by measuring resistance of the cell housing.

There are different metallic and composite based materials that may be used as coating for battery cell housing. These material's electrical resistance changes significantly (e. g., by factor of 1000), in particular in a temperature range between 80 to 300 °C, which is typical failure temperature range for battery cells. The temperature-sensitive housing according to the first aspect uses such materials, coatings or thin films to detect changes in the temperature-dependent resistance.

Preferably, the battery cell is a battery cell suitable for powering an electric vehicle or for being employed in a battery module for powering an electric vehicle, in a battery system for powering an electric vehicle, or in a battery pack for powering an electric vehicle. Here, electric vehicle may refer, e. g., to a fully electric vehicle or a hybrid vehicle (see above).

The case may have a prismatic shape. In particular, the case may have a cuboid shape.

The coating may be arranged on one or more regions of the outer surface of the case. Alternatively, the coating may be arranged on the complete outer surface of the case. The case may have a plurality of essentially planar outer side faces. The coating may be arranged on one of more regions of at least one outer side face. Alternatively, the coating may be arranged on the complete surface of at least one outer side face.

In one embodiment of the temperature-sensitive housing according to the first aspect, the case is made of a substrate material forming a substrate for the coating. Preferably, the substrate material is aluminum, or made of an alloy comprising aluminum, or made of a material comprising aluminum.

The term "substrate material" is used here simply as an easy-to-understand expression to label this material by its purpose to provide a substrate for the coating. Alternatively, a term such as "second material" could have been used instead of "substrate material," which may, however, deteriorate the intelligibility of the description.

In embodiments, the coating may comprise at least two layers. For example, the coating may contain only two layers or the coating may contain three layers.

In one embodiment of the temperature-sensitive housing, the coating comprises an insulating layer made of an electrically insulating material, wherein the insulating layer is arranged on the substrate material.

The term "insulating layer" is used here simply as an easy-to-understand expression to label this layer by its characteristic of being made of an electrically insulating material. Alternatively, a term such as "first layer" could have been used instead of "insulating layer," which may, however, decrease the intelligibility.

In embodiments, the insulating layer directly contacts the substrate material.

In one embodiment of the temperature-sensitive housing, the insulating layer is an aluminum oxide layer.

In embodiments, wherein the case is made of aluminum, the aluminum oxide (Al₂O₃) layer is the natural aluminum oxide forming on the surface of the aluminum case, due to spontaneous reaction of the aluminum material with the oxygen of the ambient air. This "natural" passivating aluminum oxide layer is about 0.05 µm thick. However, aluminum oxide layers with a thickness of 5 µm or thicker can be produced, e. g., by electrical oxidation (anodizing) or by chemical means.

Al₂O₃ is an electrical insulator. For example, an aluminum oxide layer produced by anodizing is a good electrical insulator with breakdown strengths of about 900 V at an anodized layer thickness of 30 µm. Moreover, Al₂O₃ has a relatively high thermal conductivity (around 30 Wm⁻¹K⁻¹) for a ceramic material.

Accordingly, in embodiments of the temperature-sensitive housing using a case made of aluminum, an alloy comprising aluminum, or a material comprising aluminum, the insulating layer may not have to be applied to the outer surface of the aluminum case (e. g., by anodizing), but is formed by itself ("naturally") by a reaction of the outer surface of the case with the oxygen included in the ambient air.

In one embodiment of the temperature-sensitive housing, the insulating layer is aluminum oxide or comprises aluminum oxide. The insulating layer may have a thickness of more than 0.05 µm, for example a thickness of more than 5 µm. Preferably, the insulating layer has a thickness of more than 10 µm. The insulating layer may have a thickness of more than 50 µm. Most preferably, the insulating layer has a thickness of more than 100 µm.

In other words, in such embodiments, the insulating layer is an aluminum oxide layer with a thickness larger than the thickness of an aluminum oxide layer, which would form naturally (see above) by spontaneous reaction of the aluminum included in the case with the oxygen of the ambient air. Hence, technical methods like electrical oxidation (anodizing) or chemical means may be employed to apply the insulating layer onto the outer surface of the case in those embodiments.

In one embodiment of the temperature-sensitive housing, the coating includes a temperature-sensitive layer, the temperature-sensitive layer being made of the temperature-sensitive material.

The temperature-sensitive layer is used here simply as an easy-to-understand expression to label this layer by its characteristic of being made of the temperature-sensitive material. Alternatively, a term such as "second layer" could have been used here instead of "temperature-sensitive layer," which may, however, deteriorate the intelligibility.

The temperature-sensitive layer may be formed as a film.

In preferred embodiments, the temperature-sensitive housing comprises at least one pair of electrodes. Each pair of electrodes comprising a first electrode and a second electrode, each of the first electrode and second electrode being electrically connected to the temperature-sensitive layer and being connectable to an (external) electric line or electric conduit. Thereby, the first electrode and the second electrode are connected to the temperature-sensitive layer at different positions. Then, an electric resistance can be measured between the first electrode and the second electrode. Further, the first electrode and the second electrode are connected to a contiguous region of the temperature-sensitive layer to ensure that a current can be conducted between the first and second electrode. For example, if the temperature-sensitive layer is arranged as a plurality of separated stripes on the outer surface of the case, the first and second electrode of a pair of electrodes are connected to the same stripe.

The electrodes may be formed as terminals. Also, the endings of the terminals may be accommodated in a socket configured for being connected to the plug of an (external) cable or may be accommodated in a plug configured for being connected to the socket of an (external) cable. In such embodiments the connection of the temperature-sensitive housing according to the first aspect of the invention with a measurement device or a BMU or the like may be facilitated.

In one embodiment of the temperature-sensitive housing, the temperature-sensitive layer directly contacts the insulating layer.

In such embodiments, the insulating layer may be arranged between the case (i. e., the substrate material) and the temperature-sensitive layer. In particular, the insulating layer may be sandwiched between the substrate material and the temperature-sensitive layer.

In embodiments, the temperature-sensitive layer may be made of a material or may comprise a material having a positive temperature coefficient (PTC) with regard to the material's electrical resistance. In alternative embodiments, the temperature-sensitive layer may be made of a material or may comprise a material having a negative temperature coefficient (NTC) with regard to the material's electrical resistance.

In one embodiment of the temperature-sensitive housing, the temperature-sensitive layer is made of a material comprising TiOₓ/Cr₂O₃, preferably TiO₂/Cr₂O₃.

In embodiments, wherein the temperature-sensitive layer is made of TiOₓ/Cr₂O₃, the temperature-sensitive layer has a negative temperature coefficient (NTC) with regard to its electrical resistance.

In one embodiment of the temperature-sensitive housing, the temperature-sensitive layer covers the complete outer surface of the case or at least most of the outer surface of the case.

Here, the temperature-sensitive layer may either directly contact the outer surface of the case or only indirectly cover the outer surface of the case. In the latter case, the insulating layer may be sandwiched between the case (i. e., the substrate material) and the temperature-sensitive layer. Also, the temperature-sensitive layer may cover directly the substrate material in some regions of the outer surface of the case but only indirectly cover the outer surface of the case.

In one embodiment of the temperature-sensitive housing, the temperature-sensitive layer is formed as one or more stripes arranged on the outer surface of the case.

In an embodiment of the temperature-sensitive housing, the coating comprises an outer layer covering the outer surface of the case and/or each of the other layers comprises in the coating. Preferably, the outer layer is thereby adapted for electrical insulation and/or mechanical protection.

The term "outer layer" is used here simply as an easy-to-understand expression to label this layer by its purpose to form the outermost layer of the coating applied to the case's outer surface. Alternatively, a term such as "third layer" could have been used instead of "outer layer," which may, however, deteriorate the intelligibility of the description.

In embodiments, the outer layer may be a resin layer.

It is remarked that in regions, where the outer layer covers one or more of the other layers (e. g., the temperature-sensitive layer and/or the insulating layer), the outer layer may not be in direct contact with the outer surface of the case, since the other layer(s) may be sandwiched between the outer surface of the case and the outer layer. Nonetheless, even in such regions where other layer(s) are sandwiched between the outer surface of the case and the outer layer, the outer layer covers the outer surface of the case.

In embodiments, the coating may cover the complete outer surface of the case or at least most of the outer surface of the case. In embodiments, each layer of the coating may be arranged in the same predefined region or regions of the outer surface of the case. Then, if the coating comprises a temperature-sensitive layer and an outer layer directly contacting the temperature-sensitive layer, the outer layer completely covers the temperature-sensitive layer. Then, furthermore, if the coating comprises an insulating layer and a temperature-sensitive layer directly contacting the insulating layer, the temperature-sensitive layer completely covers the insulating layer.

In alternative embodiments, the outer layer may cover more regions of the outer surface of the case than the remaining layers. In other words, in regions, where the outer surface of the case is covered by an insulating layer and/or a temperature-sensitive layer, there is also arranged an outer layer on top of the other layers, while in other regions of the outer surface of the case (i. e., regions not being covered by at least one of the insulating layer and the temperature-sensitive layer), the outer layer may directly contact the outer surface of the case.

According to a second aspect of the present disclosure, a battery module is provided, the battery module comprising: at least one battery cell, wherein at least one of the battery cells comprises a temperature-sensitive housing according to an embodiment of the first aspect.

In preferred embodiments, each of the battery module's battery cells is equipped with a temperature-sensitive housing according to the first aspect or an embodiment of the temperature-sensitive housing according to the first aspect.

In one embodiment of the battery module according to the second aspect, the battery module further comprises: one or more means for measuring an electrical resistance; one or more electric circuits, each of the circuits having a first measurement terminal and a second measurement terminal; wherein at least some of the temperature-sensitive housings are integrated into at least one of the electric circuits. Each of the means is adapted to measure the electrical resistance between the first measurement terminal and the second measurement terminal of at least one of the electric circuits.

In embodiments of the battery module, only a single means for measuring an electric resistance is used. In alternative embodiments, a plurality (e. g., two, three, four, or more) means for measuring an electric resistance are used.

In embodiments of the battery module, at least one of the means for measuring an electric resistance is an ohmmeter. In preferred embodiments of the battery module, each of the means measuring an electric resistance is an ohmmeter.

Any one of the temperature-sensitive housings may be integrated such into one of the electric circuits that a contiguous region of its temperature-sensitive material is connected to a first electrical conduit provided by the circuit at a first position and to a second electrical conduit provided by the circuit at a second position, the first and the second position being spaced apart from each other. Then, upon applying a voltage between the first and second electrical conduit, the temperature-sensitive material causes an electrical resistance between the first and second electrical conduit.

Embodiments of the battery module may comprise a plurality of temperature-sensitive housings integrated in an electric circuit, wherein all or at least some of the temperature-sensitive housings are connected in series within the circuit.

Embodiments of the battery module may comprise a plurality of temperature-sensitive housings integrated in an electric circuit, wherein all or at least some of the temperature-sensitive housings are connected in parallel within the circuit.

A third aspect of the present disclosure refers to battery system comprising: at least one battery module according to the second aspect of the disclosure; and an evaluation unit configured for: receiving a signal from each of the means for measuring an electrical resistance, the signal(s) indicating a resistance measured by the respective means for measuring an electrical resistance; detecting a deviance of each of the signals received from a means for measuring an electrical resistance from a predefined setpoint value assigned to the respective means for measuring an electrical resistance; and generating an alert signal upon detecting a deviance with an absolute value exceeding a predefined threshold.

The temperature signal generated by a means for measuring an electrical resistance may be a voltage or a digital signal. The setpoint value may be a value of a resistance, which corresponds or essentially corresponds to a value or average value of the resistance measured by the respective means for measuring an electrical resistance, when the battery system is in a normal operating state, i. e., is operating without failure. However, the setpoint value may be adapted to a load connected to the battery system.

The temperature evaluation unit may be integrated in a battery management unit (BMU) or battery management system (BMS) of the battery system or of the device equipped with the battery system.

In embodiments of the battery system, a PTC material may be employed as the temperature-sensitive material of the temperature-sensitive housings. In such embodiments, an alert signal may be generated upon detecting, by one of the means for measuring a resistance, a resistance (value) exceeding a predefined threshold (value) assigned to said means for measuring a resistance.

In embodiments of the battery system, a NTC material may be employed as the temperature-sensitive material of the temperature-sensitive housings. In such embodiments, an alert signal may be generated upon detecting, by one of the means for measuring a resistance, a resistance (value) falling below a predefined threshold (value) assigned to said means for measuring a resistance.

The alert signal generated by the battery system may be a voltage that can be measured or a digital signal that can be received by an alert unit (comprised by the apparatus employing the battery system) generating an alert (e. g., an optical and/or an acoustical signal) perceptible by the users of the apparatus employing the battery system, e. g., the driver and/or the passengers of a vehicle with such a battery system. Alternatively, alert signal generated by the battery system may directly be an alert (e. g., an optical and/or an acoustical signal) perceptible by the users of the apparatus employing the battery system.

A fourth aspect of the present disclosure relates to a vehicle comprising at least one temperature-sensitive housing according to the first aspect, and/or at least one battery module according to the second aspect, and/or at least one battery system according to the third aspect. The vehicle may be a hybrid vehicle or a fully electric vehicle.

A fifth aspect of the present disclosure deals with a method for detecting a thermal event occurring in a battery cell equipped with a temperature-sensitive housing according to an embodiment of the first aspect, the method comprising the following steps:
a) providing a first electric conduit and a second electric conduit, each of which being electrically connected, at different positions, to the temperature-sensitive material of the temperature-sensitive housing;
b) measuring, by a means for measuring an electrical resistance, an electrical resistance between the first electric conduit and the second electric conduit;
c) creating, by the means for measuring an electrical resistance, a signal indicating the measured electrical resistance;
d) transferring the signal to an evaluation unit;
e) evaluating, by the evaluation unit and based on the signal, a deviation of the measured resistance and a predefined setpoint value;
f) generating an alert signal upon detecting a deviation having an absolute value exceeding a predefined threshold.

In embodiments of the method, step e) of evaluating a deviation may comprise a sub-step of converting the signal received from the means for measuring an electrical resistance into a value.

Further aspects of the present disclosure could be learned from the dependent claims or the following description.

### Specific Embodiments

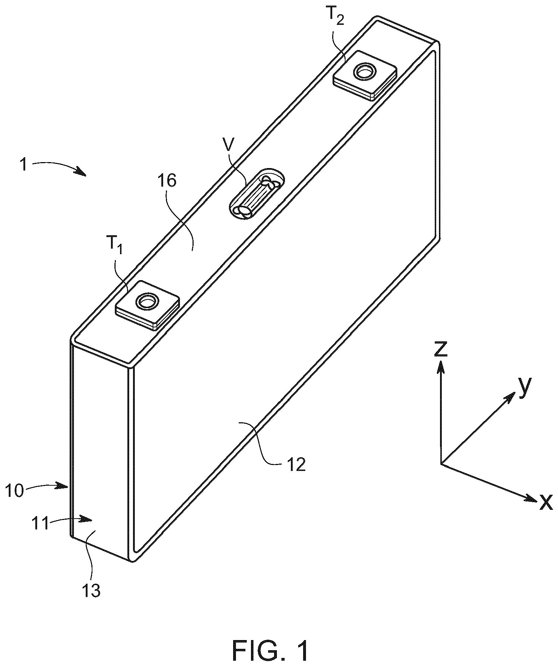

Figure 1 is a perspective view illustrating a typical design of a state-of-the-art battery cell 1 used, e. g., in a battery module for an electric or hybrid vehicle. To facilitate the following description, a Cartesian coordinate system with axes x, y, and z is also depicted in Fig. 1. The illustrated battery cell 1 has a prismatic (cuboid) shape essentially defined by a housing 10. In particular, the housing 10 is built by a case 11 including six essentially planar side faces. A rear side (not shown) of the case 11 is arranged perpendicular to the x-axis, and a front side 12 with a shape congruent to the rear side is arranged opposite to the rear side, the front side 12 being likewise perpendicular to the x-axis. Further, the housing 10 includes a first lateral side 13 arranged perpendicular to the y-axis, and a second lateral side (not shown) with a shape congruent to first lateral side is arranged opposite to the first lateral side 13, the second lateral side being likewise perpendicular to the y-axis. Finally, a bottom side (not shown) is arranged perpendicular to the z-axis, and an upper side 16 with a shape congruent to the bottom side is arranged opposite to the bottom side, the upper side 16 being likewise perpendicular to the z-axis. In the example, the front side 12 and the rear side have the largest areas compared to the remaining side faces of the housing 10.

On the upper side 16 of the housing 10 (i. e., the battery cell's side surface facing into the z-direction of the coordinate system), a first cell terminal T₁ and a second cell terminal T₂ are arranged. The first and second cell terminals T₁, T₂ allow for an electrical connection of the battery cell 1. The first cell terminal T₁ may be the negative terminal of the battery cell 1, and the second cell terminal T₂ may be the positive terminal of the battery cell 1. Furthermore, between the first cell terminal T₁ and the second cell terminal T₂, a venting outlet V is arranged on the upper side 16. Accordingly, the upper side 16 will in the following be referred to as the "venting side" of battery cell 1 or its housing 10.

Through the venting outlet V, vent gas can be ejected from the battery cell 1 in case of a thermal event occurring in the battery cell 1 such as a thermal runaway. Inside the battery cell 1, a valve (not shown) is usually installed upstream of the venting outlet, the valve being configured to open, if the gas pressure inside the battery cell exceeds a predefined value, and to remain in a closed stated otherwise, i. e., when the gas pressure inside the battery cell is below the predefined value. Thus, before being output via the venting outlet V, the vent gas may pass the venting valve arranged inside the battery cell 1.

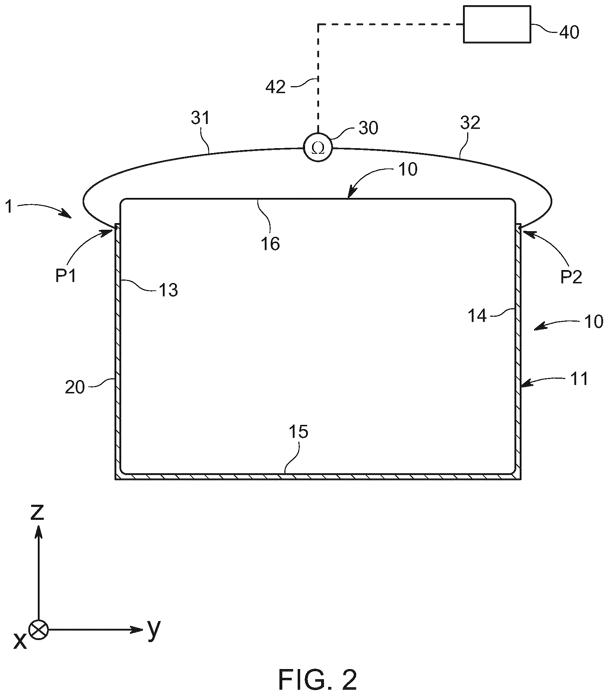

Figure 2 is a schematic longitudinal cut (parallel to the y-z-plane of the coordinate system) through an embodiment of a housing 10 for a battery cell 1 according to the invention. In the example, the overall shape of the housing 10 corresponds to that of the state-of-the-art housing 10 as described before with reference to Fig. 1. However, at least some of outer surfaces of side faces of the housing are covered-or at least partly covered-by a coating 20. As can be taken from Fig. 2, the coating 20 covers outer surfaces of a first lateral side 13 and a second lateral side 14 as well as an outer surface of a bottom side 15 of the housing 10. An upper side 16 of the housing 10 may not be covered by the coating 20, as cell terminals T₁, T₂ (not shown in Fig. 2) and/or a venting outlet V (not shown in Fig. 2) may be arranged on the upper side 16.

In embodiments of the housing according to the invention, at least one of a front side and a rear side may also be covered by the coating 20.

In alternative embodiments of the housing according to the invention, the front side and the rear side may not be covered by the coating 20. In such embodiments, in other words, only the first and second lateral sides 13, 14 and the bottom side 15 may be covered by the coating 20.

The coating 20 includes a material that exhibits a temperature-dependent electrical resistance, which will be referred to as "temperature-sensitive material" in the following. Hence, a resistance can be measured between two different positions on the coating 20. Here, a resistance is measured between a first position P₁ and a second position P₂, the first position P₁ located in an upper area of the first lateral side 13 and the second position P₂ located in an upper area of the second lateral side 14. An ohmmeter 30 can be used to measure the resistance of the coating 20 between the first and second positions P₁, P₂. Therefore, the ohmmeter 30 can be connected to the first position P₁ on the coating 20 by means of a first wire 31 and can be further connected to the second position P₂ on the coating 20 by means of a second wire 32. The ohmmeter 30 is configured to generate a signal indicative of the measured resistance. The signal may be an analog signal or a digital signal. The signal may be transferred to an evaluation unit 40. To transfer the signal from the ohmmeter 30 to the evaluation unit 40, a signal line 42 such as a cable, a pair of wires or the like may be used. Alternatively, the signal may be transferred wirelessly to the evaluation unit 40. Also, the signal may be permanently or at least periodically transferred to the evaluation unit 40.

Accordingly, when a thermal event such as a thermal runaway occurs in the battery cell accommodated within the housing 10 as illustrated in Fig. 2, the housing 10 becomes heated from inside, and the heat will be transferred through the side faces of the housing 10 such that the temperature of the coating 20 will be also increased. Since, as already pointed out above, the coating 20 includes a temperature-sensitive material, the resistance of that material will change as a consequence of this heating process. Depending on the configuration of the temperature-sensitive material, the measured resistance may increase or decrease as the temperature of the coating 20 increases. If the temperature-sensitive material is a material having a positive temperature coefficient (PTC) with regard to its electrical resistance, the measured resistance increases, when the temperature of the coating 20 rises. On the other hand, if the temperature-sensitive material is a material having a negative temperature coefficient (NTC) with regard to its electrical resistance, the measured resistance decreases, when the temperature of the coating 20 rises.

As the evaluation unit 40 is permanently or at least periodically fed with a signal indicative of the coating's temperature, the evaluation unit 40 can monitor the temperature of the coating 20, which is in turn indicative of the temperature inside the housing 10, i. e., the temperature of the battery cell accommodated inside the housing 10. Hence, the thermal state of the battery cell accommodated inside the housing 10 can be monitored by the evaluation unit 40.

The evaluation unit 40 may be configured for comparing the measured resistance with a predefined setpoint value for the resistance, i. e., a value of the resistance expected to be measured when the battery cell is working correctly. For comparing the measured resistance with the predefined setpoint value, this may include that the evaluation unit 40 converts the received signal from the ohmmeter 30 to a value. In embodiments, the comparison may be performed digitally using a CPU. In such cases, the evaluation unit 40 may comprise a microcontroller.

If, at a certain point of time t, the measured resistance is denoted by Rₘ(t) and the setpoint value is denoted by R₀, a deviation ΔR may be obtained using the formula ΔR(t) := Rₘ(t) - R₀. Then, if a PTC material is used as the temperature-sensitive material, the evaluation unit 40 may generate an alert, when, at a certain point in time t, a deviation ΔR(t) with ΔR(t) > Sₚₒₛ with a predefined threshold Sₚₒₛ is detected, wherein the threshold Sₚₒₛ may be a positive value. Alternatively, the evaluation unit 40 may generate an alert, when an average deviation ΔR(t) with ΔR(t) > Sₚₒₛ is detected, wherein the average deviation ΔR(t) is the average of ΔR(τ) for all times τ in a time interval [t - δt, t] having the duration δt. Thereby, the average can be calculated using an arithmetic mean, a weighted arithmetic mean, a median, a quadratic mean, or any other kind of calculating an average value. In any case, the threshold Sₚₒₛ may depend on the electric load, which is powered by the battery cell, and/or on the used temperature-sensitive material, and/or on the geometry of the temperature-sensitive material used in the coating 20, and/or on the positions P₁, P₂.

On the other hand, if an NTC material is used as the temperature-sensitive material, evaluation unit 40 may generate an alert, when, at a certain point in time t, a deviation ΔR(t) with ΔR(t) < S_{neg} with a predefined threshold S_{neg} is detected, wherein the threshold S_{neg} may be a negative value. Alternatively, the evaluation unit 40 may generate an alert, when an average deviation Δ̅R̅ (t) with Δ̅R̅ (t) < S_{neg} is detected, wherein the average deviation Δ̅R̅ (t) is the average of ΔR(τ) for all times τ in a time interval [t - δt, t] having the duration δt. Thereby, the average can be calculated using an arithmetic mean, a weighted arithmetic mean, a median, a quadratic mean, or any other kind of calculating an average value. In any case, the threshold S_{neg} may depend on the electric load, which is powered by the battery cell, and/or on the used temperature-sensitive material, and/or on the geometry of the temperature-sensitive material used in the coating 20, and/or on the positions P₁, P₂.

However, a positive threshold S may be used irrespectively of using a PTC or an NTC material when an absolute value |ΔR(t)| is used to measure the deviation instead of only the difference as in the examples above. Then, the evaluation unit 40 may generate an alert, when, at a certain point in time t, an absolute deviation |ΔR(t)| with |ΔR(t)| > S with a predefined threshold S > 0 is detected. Alternatively, the evaluation unit 40 may generate an alert, when an absolute average deviation |Δ̅R̅(t)| with |Δ̅R̅(t)| > S is detected, wherein the absolute average deviation |Δ̅R̅(t)| is the absolute value of the average of ΔR(τ) for all times τ in a time interval [t - δt, t] having the duration δt. Of course, instead of |Δ̅R̅(t)| > S one may equivalently use (Δ̅R̅(t))² > S² with Δ̅R̅(t) as defined above in the context of using a PCT or NTC material.

In some embodiments of the housing 10, the locations of the first point P₁ and the second point P₂ are chosen such that the distance between these points is large. This is realized by the exemplary embodiment shown in Fig. 2, since the first and the second point P₁, P₂ are arranged on the first and second lateral sides 13, 14 being opposite to each other with respect to the largest extension of the housing 10, viz. its extension along the y-direction. Choosing a large distance between the first and second points P₁, P₂ has two advantages. First, the measurement of the resistance of the coating 20 becomes more accurate, as incidental local variances of the resistance (e. g., due to variances of the thickness of the coating 20) are averaged out. Second, in this case, the measured resistance correlates to an average temperature of a large region of the outer surface of the case accommodating the battery cell, thus allowing for the detection of a thermal event independently of the location within the battery cell, at which the thermal event is strongest or, in the starting phase of the thermal event, independently of the location within the battery cell, at which the thermal event begins.

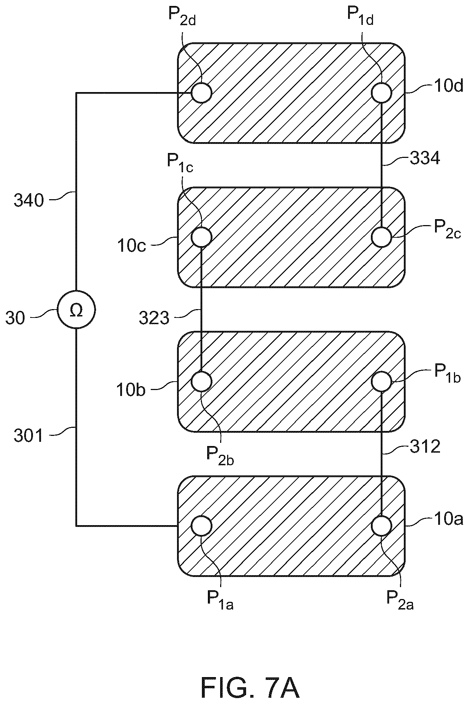

In the example illustrated in Fig. 2, the resistance becomes only measured with respect to (the coating 20) of the housing 10, or, more precisely, with respect to two points P1, P2 on the temperature-sensitive material included in the coating 20 of the housing 10. However, other embodiments can be used, which will explained in more detail below with reference to Figs. 7A to 7C.

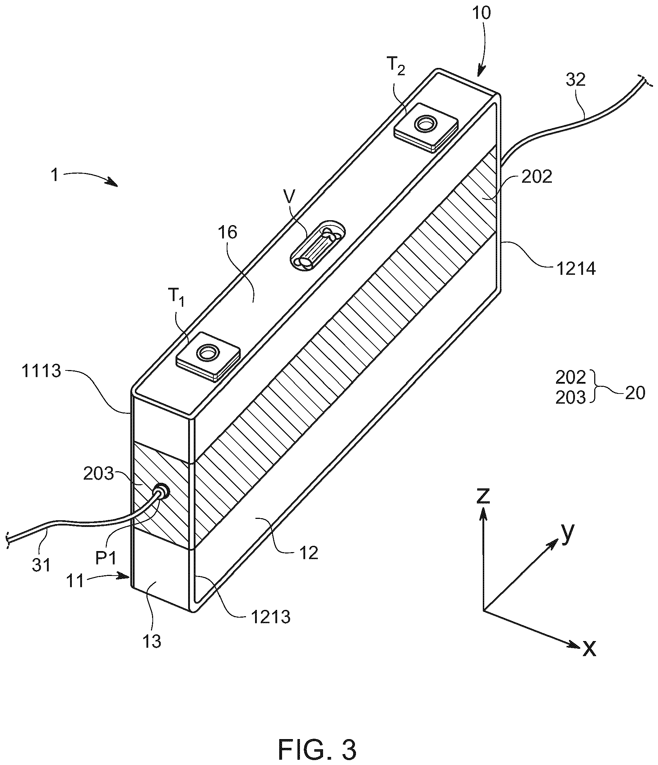

Also, in the example illustrated in Fig. 2, the complete bottom side 15 and at least the major parts of the first and second lateral sides 13, 14 (and, in embodiments, also the front side and the rear side, each of which not visible in the longitudinal cut of Fig. 2) are covered with the coating 20. However, in some embodiments of a housing for a battery cell, only parts of one or more side faces of the housing may be covered with a coating. In Figure 3, a battery cell 1 with a housing 10 is schematically depicted, wherein a coating 20 is formed at least by a stripe 202 arranged in a middle portion (with respect to the z-axis) of a front side 12 and a further stripe 203 arranged in a middle portion (with respect to the z-axis) of a first lateral side 13. However, further stripes may be arranged in a corresponding way on a rear side (not shown) and a second lateral side (not shown) of the housing 10. The stripes 202, 203 forming the coating 20 in the depicted example (and the temperature-sensitive material included in each of the stripes) are electrically connected to each other. In other words, the stripe 202 on the front side 12 is linked to the stripe 203 on the first lateral side 13 on a vertical edge 1213 of the housing 10 formed between the front side 12 and the first lateral sides 13. Correspondingly, a stripe on the second lateral side (not shown) may be linked (i. e., electrically connected) to the stripe 202 on the front side 12 across a vertical edge 1214 between the front side 12 and the second lateral side as well as to a stripe on the rear side (not shown) across a vertical edge (not shown) between the second lateral side and the rear side. Eventually, a stripe arranged on the rear side is electrically connected in turn to the stripe 203 arranged on the first lateral side 13.

Then, the resistance of the coating 20 may be measured between the first position P₁ located in a center area of the stripe 203 arranged on the first lateral side 13 and the second position P₂ (not shown) located correspondingly in a center area of the stripe arranged on the second lateral side. To that end, a first wire 31 is electrically connected to the coating 20 (i. e., to its portion formed by the stripe 203) at the first position P₁ and, correspondingly, a second wire 32 is electrically connected to the coating 20 (i. e., to its portion formed by the stripe arranged on the second lateral side) at the second position P₂. Then, the resistance of the coating between the first and the second positions P₁, P₂ can be measured, e. g., using the ohmmeter 30 correspondingly to the arrangement illustrated in Fig. 2. Also, the evaluation of the measurement and the generation of alerts may be performed similar to that described in the context of Fig. 2.

Alternatively, however, the resistance may not be measured with regard to an individual housing but with regard to a group of housings, as will be explained below with reference to Figs. 7A to 7C. In such cases, the first wire 31 and/or the second wire 32 may not be directly connected to the ohmmeter 30 but may instead be connected to one or more further housings similar to that depicted in Fig. 2.

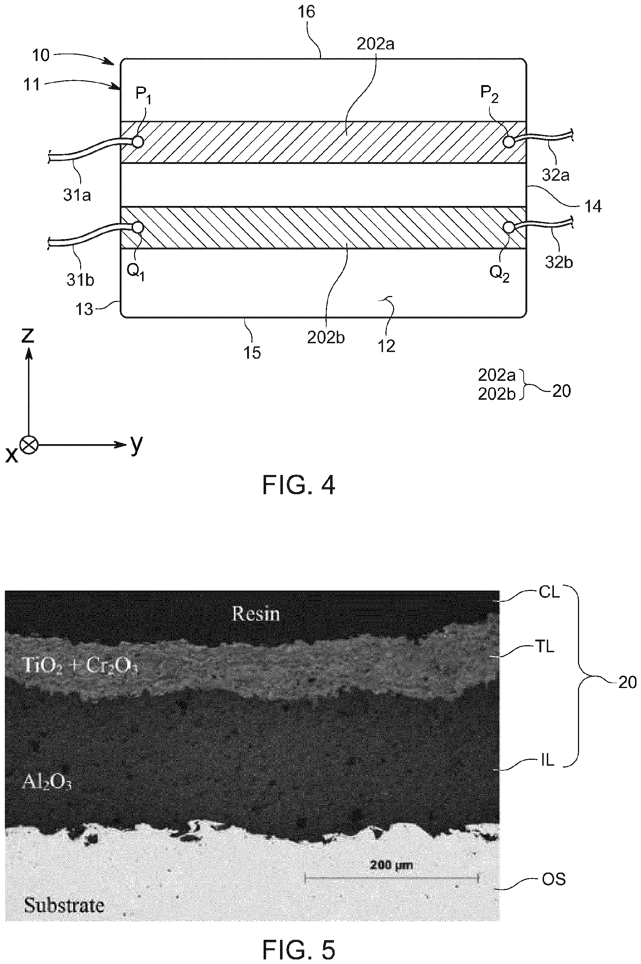

A further embodiment of a housing according to the invention is schematically illustrated by Figure 4 providing a side view onto a housing 10 into the direction against the x-axis of the coordinate system. Again, as in all illustrations herein, the reference signs referring to the side faces of the housing 10 correspond to that introduced with respect to the state-of-the-art battery housing of Fig. 1. In the embodiment of Fig. 4, a coating 20 is formed by two separated stripes being arranged on the front side 12 of the housing 10, i. e., by an upper stripe 202a and a lower stripe 202b. Hence, in this example, the coating 20 is not contiguous but includes two regions, which are not electrically connected to each other.

Each of the upper stripe 202a and the lower stripe 202b has a certain width with respect to the z-direction and extends, along the y-direction, between the opposite vertical edges of the front side 12 to the first lateral side 13 and to the second lateral side 14. As to the upper stripe 202a, the resistance may be measured between a first upper point P₁ located on the upper stripe 202a in the vicinity to the first lateral side 13 and a second upper point P₂ located on the upper stripe 202a in the vicinity to the second lateral side 14. Further, as to the lower stripe 202b, the resistance may be measured between a first lower point Q₁ located on the lower stripe 202b in the vicinity to the first lateral side 13 and a second lower point Q₂ located on the lower stripe 202b in the vicinity to the second lateral side 14.

A first upper wire 31a is connected to the first upper point P₁, and a second upper wire 32a is connected to the second upper point P₂. Correspondingly, a first lower wire 31b is connected to the first lower point Q₁, and a second lower wire 32b is connected to the second lower point Q₂. In embodiments, the first upper point P₁ and the second upper point P₂ may be connected to a first ohmmeter (not shown) to measure a resistance between the first and second upper points P₁, P₂. Also, the first lower point Q₁ and the second lower point Q₂ may be connected to a second ohmmeter (not shown) to measure a resistance between the first and second lower points Q₁, Q₂.

Alternatively, the first and second upper wires 31a, 32a may be used to connect the upper stripes of each housing of a group of housings according to the housing 10 as shown in Fig. 4 within an electric circuit. Correspondingly, the first and second lower wires 31b, 32b may be used to connect the lower stripes of each housing of a group of housings according to the housing 10 as shown in Fig. 4 within an electric circuit. For example, by a first electric circuit (not shown), the upper stripes of a group of housings according to that depicted in Fig. 4 may be connected in series or connected in parallel. Also, by a second electric circuit (not shown), the lower stripes of a group of housings according to that depicted in Fig. 4 may be connected in series or connected in parallel. Then, a first ohmmeter (not shown) may be configured to measure the overall resistance of the first electric circuit, and a second ohmmeter (not shown) may be configured to measure the overall resistance of the second electric circuit.

The coating in the region of the upper stripe 202a may be made of the same material or may be composed identically or similar to the coating in the region of the lower stride 202b. Then, using the two stripes 202a, 202b may provide redundancy such that a monitoring of the thermal state of the battery cell accommodated in the housing 10 is still possible, even in the case of a deficiency or failure of one of the stripes.

Alternatively, however, the upper stripe 202a may be made of a material different to the material employed in the lower stripe 202b, or the upper stripe 202a may at least be composed differently from the lower stripe 202b. This may improve the accuracy of the temperature-monitoring of the housing 10 over a large interval of temperatures. For example, the upper stripe 202a may be include a material having a positive temperature coefficient (PTC) with regard to electrical resistance, and the lower stripe 202b may be include a material having a negative temperature coefficient (NTC) with regard to electrical resistance. Alternatively, the upper stripe 202a may be include a material having a negative temperature coefficient (NTC) with regard to electrical resistance, and the lower stripe 202b may be include a material having a positive temperature coefficient (PTC) with regard to electrical resistance.

In fact, there are different metallic and composite based materials that can be used in the coating 20 as a temperature-sensitive material. These material's electrical resistance changes significantly (e. g. by factor of 1000), especially in a temperature range between 80 °C to 300 °C, which is a typical temperature range for failure of battery cells. Hence, different temperature-sensitive materials used in different stripes (in embodiments, even more than two stripes may be used), a large temperature range can be covered at a high accuracy.

Also, in embodiments, the upper and lower stripe may be shaped differently. For example, any one of the upper stripe and the lower stripe can run around the whole housing 10 in a similar way as described before with reference to Fig. 3, while the upper stripe is still separated from the lower stripe. In such embodiments, the first upper and first lower measurement points P₁, Q₁ may each be formed on the first lateral side 13, and the second upper and second lower measurement points P₂, Q₁₂ may each be formed on the second lateral side 14.

In each of the exemplary embodiments shown in Figs. 2 to 4, the case 11 of the housing 10 may be made of aluminum. Further, in each of these embodiments, the coating 20 may be composed as described in the following with reference to Fig. 5.

Figure 5 is a cross-sectional image (based on an image taken from Ref. [1]) showing the microstructure of an example of a coating that can be used in embodiments of the case of a housing 20 according to the invention. In such embodiments, the substrate corresponds to a portion of the outer surface OS of the case of a housing 20, and a coating 20 is applied to the substrate, wherein the coating 20 includes three layers IL, TL, CL that will be explained below.

The outer surface OS may be a part of any one of the side faces of the case in a region, where the outer surface of the case is covered by the coating 20, e. g., in the region of the stripe 202 arranged on the front side 12 as illustrated in Fig. 3. In the example of Fig. 5, the case is made of Aluminum (Al). The coating 20 includes several layers. Specifically, a layer of an insulating material IL may be arranged directly on the shown portion of the outer surface OS of the case. In the example of Fig. 5, the insulating layer is made of aluminum oxide (Al₂O₃), which is an electrical insulator. When aluminum is exposed to air, an aluminum oxide layer forms naturally aluminum due to spontaneous reaction of the aluminum with the oxygen of the ambient air. However, the "natural" passivating aluminum oxide layer is about 0.05 µm thick and may thus be too small to for the requirements for an insulating layer in the present case. Thus, in embodiments of the disclosed housing for a battery cell, it is preferred that thicker aluminum oxide layers are used (e. g., Al₂O₃ layers with a thickness of at least 5 µm), which can be produced, e. g., by electrical oxidation (anodizing) or by chemical means.

On the insulating layer IL, a temperature-sensitive layer TL is arranged, which is made of a material having a temperature-dependent electrical resistance. Due to the insulating layer IL sandwiched between the temperature-sensitive layer TL and the outer surface OS of the case, the temperature-sensitive layer TL is electrically insulated from the case. In the example, the material of the temperature-sensitive layer TL is TiO₂/Cr₂O₃. The TiO₂/Cr₂O₃ layer may be thinner than the Al₂O₃ layer acting as insulating layer IL.

Finally, a closing layer CL may be arranged on the temperature-sensitive layer TL as an outermost layer to protect both, the insulating layer IL and the temperature-sensitive layer TL against undesired mechanical influences such as impacts, scratches, etc., as well as to provide electrical insulation from external members that may come into mechanical contact with the outer surface of the coating 20. In embodiments, resin may be used as closing layer CL, as shown in the example of Fig. 5.

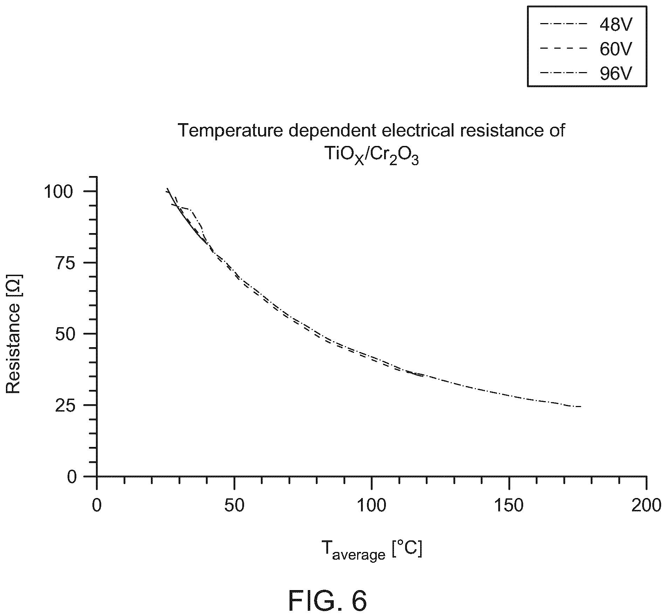

Figure 6 is a diagram illustrating the electric resistance R(T_{average}) of the TiO₂/Cr₂O₃ layer as a function depending on the average temperature T_{average} of the TiO₂/Cr₂O₃ layer as depicted in Fig. 5 (Fig. 6 also based on an image of Ref. [1]). To that end, a voltage can be applied between two points of the layer (e. g., between the first and second points P₁, P₂ as exemplarily described before with reference to Figs. 2 to 4) and the resulting current can be measured. Then, the resistance R can be obtained using the Ohm's law R(T_{average}) = U / I(T_{average}), with U being the applied voltage and I(T_{average}) denoting the measured current being dependent on the average temperature T_{average} of the TiO₂/Cr₂O₃ layer. The diagram Fig. 6 shows the result of three exemplary measurements, using the voltages U = 48 V (solid line), U = 60 V (dotted line), and U = 96 V (dashed line), respectively. During the measurement, the average temperature T_{average} of the TiO₂/Cr₂O₃ layer has been varied in the range between about 25 °C and 170 °C.

Finally, several possibilities of monitoring the temperature state of a group of battery cell housings according to the present disclosure are illustrated in Figures 7A to 7C. In each of Figs. 7A to 7C, an embodiment of a battery module including a stack of four battery cells is shown, each of the battery cells being accommodated in a housing 10a, 10b, 10c, 10d according to the present disclosure. Of course, any one of the shown examples can be easily generalized to battery modules having stacks with a different number of battery cells, for example, stacks having a number of battery cells larger than four. Each of the housings 10a, 10b, 10c, 10d can be designed, for example, like one of the housings depicted in Fig. 2 or Fig. 3. In this embodiment, each of the housings 10a, 10b, 10c, 10d are covered with a coating (indicated here without reference number by the hatching of the shown side faces of the housings, although the coating may not necessarily cover the complete shown side faces). On the coating of each of the housings 10a, 10b, 10c, 10d, a pair of measurement points (P₁ₐ, P₂ₐ), (P_{1b}, P_{2b}), (P_{1c}, P_{2c}), (P_{1d}, P_{2d}) is chosen, respectively.

Between the two points of each of the pairs (P₁ₐ, P₂ₐ), (P_{1b}, P_{2b}), (P_{1c}, P_{2c}), (P_{1d}, P_{2d}), a resistance of the respective coating can be measured. In the following description, for each of the examples shown in Figs. 7A to 7C, the (temperature-dependent) resistance between the first pair (P₁ₐ, P₂ₐ) will be denoted by Rₐ(Tₐ), the (temperature-dependent) resistance between the second pair (P_{1b}, P_{2b}) will be denoted by R_{b}(T_{b}), the (temperature-dependent) resistance between the third pair (P_{1c}, P_{2c}) will be denoted by R_{c}(T_{c}), and the (temperature-dependent) resistance between the fourth pair (P_{1d}, P_{2d}) will be denoted by R_{d}(T_{d}). Here, the temperatures Tₐ, T_{b}, T_{c}, T_{d} refer to the average temperatures of the coatings of the respective housings 10a, 10b, 10c, 10d between the measurement points of the respective pairs (P₁ₐ, P₂ₐ), (P_{1b}, P_{2b}), (P_{1c}, P_{2c}), (P_{1d}, P_{2d}) of measurement points.

By electric conduits (indicated by the lines) to the measurement points, the housings 10a, 10b, 10c, 10d are integrated into an electric circuit connected to one or more ohmmeters 30, 30a, 30b, 30c, 30d. However, the arrangement of the components in the electric circuits of the examples shown differs. Note that these electric circuits are solely used to monitor the temperature-state of the groups of battery cells and are thus completely independent from circuits used for tapping the voltage generated by the battery cells of the battery modules. The circuits used for tapping the voltage generated by the battery cells of the battery modules are not illustrated in Figs. 7A to 7C for the sake of simplicity.

In the embodiment of a battery module shown in Fig. 7A, the coatings of the four housings 10a, 10b, 10c, 10d are connected. For example, a second measurement point P₂ₐ of the first housing 10a is electrically connected to a first measurement point P_{1b} of the second housing 10b by a wire 312, a second measurement point P_{2b} of the second housing 10b is electrically connected to a first measurement point P_{1c} of the third housing 10c by a wire 323, and a second measurement point P_{2c} of the third housing 10c is electrically connected to a first measurement point P_{1d} of the fourth housing 10d by a wire 334. Further, an ohmmeter 30 is connected to a first measurement point P₁ₐ of the first housing 10a by a wire 301 and to a second measurement point P_{2d} of the fourth housing 10d by a wire 340. Accordingly, with the resistances measured for the pairs of measurement points and the temperatures of the coatings of the housings denoted as described above, the ohmmeter 30 is configured to measure an overall resistance R(Tₐ, T_{b}, T_{c}, T_{d}) = Rₐ(Tₐ) + R_{b}(T_{b}) + R_{c}(T_{c}) + R_{d}(T_{d}) in the example of Fig. 7A. Hence, if the coatings of each housings 10a, 10b, 10c, 10d include a PTC material, the overall resistance R(Tₐ, T_{b}, T_{c}, T_{d}) will increase, when at least one of the temperatures Tₐ, T_{b}, T_{c}, T_{d} increases. On the other hand, if the coatings of each housings 10a, 10b, 10c, 10d include an NTC material (e. g., a TiOₓ/Cr₂O₃ layer as described above with reference to Fig. 5), the overall resistance R(Tₐ, T_{b}, T_{c}, T_{d}) decreases upon an increase of at least one of the temperatures Tₐ, T_{b}, T_{c}, T_{d}.

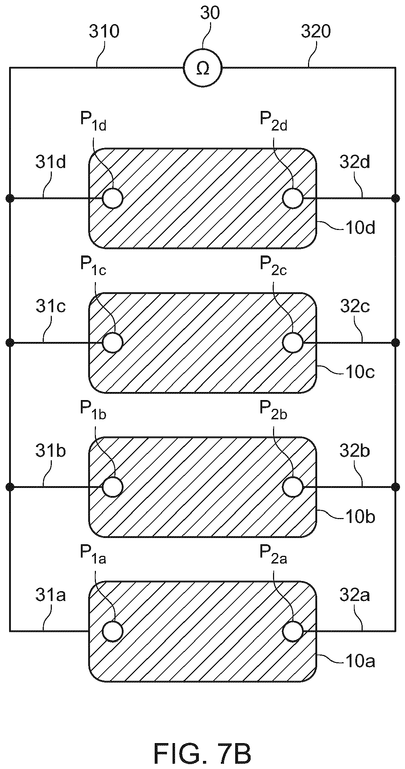

In the embodiment of a battery module shown in Fig. 7B, the coatings of the four housings 10a, 10b, 10c, 10d are connected in parallel. For example, each of the first measurement points P₁ₐ, P_{1b}, P_{1c}, P_{1d} on the coatings of the respective housings 10a, 10b, 10c, 10d is connected to a first wire 310, and each of the second measurement points P₁ₐ, P_{1b}, P_{1c}, P_{1d} on the coatings of the respective housings 10a, 10b, 10c, 10d is connected to a second wire 320. An ohmmeter 30 is connected to the first wire 310 and the second wire 320. Accordingly, with the resistances measured for the pairs of measurement points and the temperatures of the coatings of the housings denoted as described above, the ohmmeter 30 is configured to measure an overall resistance R(Tₐ, T_{b}, T_{c}, T_{d}) = [1 / Rₐ(Tₐ) + 1 / R_{b}(T_{b}) + 1 / R_{c}(T_{c}) + 1 / R_{d}(T_{d})]⁻¹ in the example of Fig. 7B. Hence, if the coatings of each housings 10a, 10b, 10c, 10d include a PTC material, the overall resistance R(Tₐ, T_{b}, T_{c}, T_{d}) will increase, when at least one of the temperatures Tₐ, T_{b}, T_{c}, T_{d} increases. On the other hand, if the coatings of each housings 10a, 10b, 10c, 10d include an NTC material (e. g., a TiOₓ/Cr₂O₃ layer as described above with reference to Fig. 5), the overall resistance R(Tₐ, T_{b}, T_{c}, T_{d}) decreases upon an increase of at least one of the temperatures Tₐ, T_{b}, T_{c}, T_{d}.

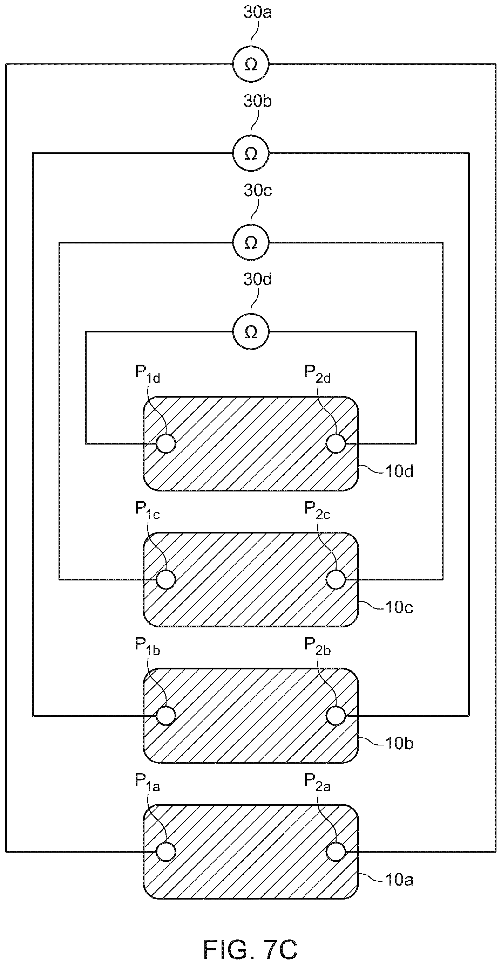

Finally, in the embodiment of a battery module shown in Fig. 7C, the average temperature Tₐ, T_{b}, T_{c}, T_{d} of the coatings of each of the respective housings 10a, 10b, 10c, 10d is measured individually. To that end, a first ohmmeter 30a is connected to the points P₁ₐ, P₂ₐ of the first pair of measurement points (P₁ₐ, P₂ₐ) located on the coating of the first housing 10a. A second ohmmeter 30b, a third ohmmeter 30c, and a fourth ohmmeter 30d are connected to the coatings of the second housing 10b, the third housing 10c, and the fourth housing 10d, respectively. This example allows for the most precise monitoring of the average temperature Tₐ, T_{b}, T_{c}, T_{d} of the coatings of each of the respective housings 10a, 10b, 10c, 10d in comparison to the examples described above with reference to Figs. 7A and 7B. On the other hand, of course, the manufacture costs of the examples of Figs. 7A and 7B are lower in comparison to the example of Fig. 7C, since in the examples of Figs. 7A and 7B, only a single ohmmeter 30 is necessary.

### Reference signs

- 1: battery cell
- 10: housing
- 10a, 10b, 10c, 10d: housings
- 11: case
- 12: front side
- 13: first lateral side
- 14: second lateral side
- 15: bottom side
- 16: upper side
- 20: coating
- 30: ohmmeter
- 30a, 30b, 30c, 30d: ohmmeters
- 31: wire
- 31a, 31b, 31d, 31d: wires (electric conduits)
- 32: wire
- 32a, 32b, 32c, 32d: wires (electric conduits)
- 40: evaluation unit
- 42: signal line
- 202: stripe of coating
- 202a, 202b: stripes of coating
- 203: stripe of coating
- 301, 310, 312, 320: electric conduits (wires)
- 323, 334, 340: electric conduits (wires)
- 1113, 1213, 1214: vertical edges

- CL: closing layer
- IL: insulating layer
- OS: outer surface of case
- P₁, P₂: points on coating
- P₁ₐ, P₂ₐ: points on coating
- P_{1b}, P_{2b}: points on coating
- P_{1c}, P_{2c}: points on coating
- P_{1d}, P_{2d}: points on coating
- Q₁, Q₂: points on coating
- T_{average}: average temperature
- T₁, T₂: cell terminals
- TL: temperature-sensitive layer
- V: venting outlet
- x, y, z: axes of a Cartesian coordinate system

### Literature

[1] K. Bobzin et al. 2019, IOP Conf. Ser.: Mater. Sci. Eng. 480 012002

## Claims

1. A temperature-sensitive housing for a battery cell, comprising:
a case having an outer surface; and
a coating,
wherein the coating at least partially covers the outer surface of the case; and
wherein the coating comprises a temperature-sensitive material having a temperature-dependent electrical resistance.

2. The temperature-sensitive housing according to claim 1,
wherein the case is made of a substrate material forming a substrate for the coating;
wherein the substrate material is aluminum, or made of an alloy comprising aluminum, or made of a material comprising aluminum.

3. The temperature-sensitive housing according to claim 1 or 2,
wherein the coating comprises an insulating layer made of an electrically insulating material;
wherein the insulating layer is arranged on the substrate material.

4. The temperature-sensitive housing according to claim 3, wherein the insulating layer is an aluminum oxide layer.

5. The temperature-sensitive housing according to claim 3 or 4,
wherein the insulating layer is aluminum oxide or comprises aluminum oxide; and
wherein the insulating layer has a thickness of more than 0.05 µm, for example a thickness of more than 5 µm, preferably a thickness of more than 10 µm, more preferably a thickness of more than 50 µm, and most preferably a thickness of more than 100 µm.

6. The temperature-sensitive housing according to any one of claims 1 to 5, wherein the coating comprises a temperature-sensitive layer, the temperature-sensitive layer being made of the temperature-sensitive material.

7. The temperature-sensitive housing according to any one of claims 3 to 5 or, as far as depending on claim 3, according to claim 6, wherein the temperature-sensitive layer directly contacts the insulating layer.

8. The temperature-sensitive housing according to claim 6 to 7, wherein the temperature-sensitive layer is made of a material comprising TiOₓ/Cr₂O₃, preferably TiO₂/Cr₂O₃.

9. The temperature-sensitive housing according to any one of claims 6 to 8, wherein the temperature-sensitive layer covers the complete outer surface of the case or at least most of the outer surface of the case.

10. The temperature-sensitive housing according to any one of claims 6 to 8, wherein the temperature-sensitive layer is formed as one or more stripes arranged on the outer surface of the case.

11. A battery module comprising:
at least one battery cell,
wherein at least one of the battery cells comprises a temperature-sensitive housing according to any one of claims 1 to 10.

12. The battery module according to claim 11, further comprising:
one or more means for measuring an electrical resistance;
one or more electric circuits, each of the circuits having a first measurement terminal and a second measurement terminal;
wherein at least some of the temperature-sensitive housings are integrated into at least one of the electric circuits; and
wherein each of the means is adapted to measure the electrical resistance between the first measurement terminal and the second measurement terminal of at least one of the electric circuits.

13. A battery system comprising:
at least one battery module according to claim 11 or 12; and
an evaluation unit configured for:
receiving a signal from each of the means for measuring an electrical resistance, the signal(s) indicating a resistance measured by the respective means for measuring an electrical resistance;
detecting a deviance of each of the signals received from a means for measuring an electrical resistance from a predefined setpoint value assigned to the respective means for measuring an electrical resistance; and
generating an alert signal upon detecting a deviance with an absolute value exceeding a predefined threshold.

14. A vehicle comprising at least one temperature-sensitive housing according to any one of claims 1 to 10, or at least one battery module according to claim 11 or 12, or at least one battery system according to claim 13.

15. A method for detecting a thermal event occurring in a battery cell equipped with a temperature-sensitive housing according to any one of claims 1 to 10, the method comprising the following steps:
a) providing a first electric conduit and a second electric conduit, each of which being electrically connected, at different positions, to the temperature-sensitive material of the temperature-sensitive housing;
b) measuring, by a means for measuring an electrical resistance, an electrical resistance between the first electric conduit and the second electric conduit;
c) creating, by the means for measuring an electrical resistance, a signal indicating the measured electrical resistance;
d) transferring the signal to an evaluation unit;
e) evaluating, by the evaluation unit and based on the signal, a deviation of the measured resistance and a predefined setpoint value;
f) generating an alert signal upon detecting a deviation having an absolute value exceeding a predefined threshold.

## Amended claims

### Amended claims in accordance with Rule 137(2) EPC.

1. A temperature-sensitive housing (10) for a battery cell (1), comprising:
a case (11) having an outer surface (OS); and
a coating,
wherein the coating at least partially covers the outer surface of the case (11);
wherein the coating is formed by a first stripe (202a) and a second stripe (202b) being separated from each other;
wherein the first stripe (202a) is made of a first material and the second stripe (202b) is made of a second material different from the first material; and
wherein the first material has a positive temperature coefficient with regard to the electrical resistance and the second material has a negative temperature coefficient with regard to the electrical resistance.

2. The temperature-sensitive housing (10) according to claim 1,
wherein the case (11) is made of a substrate material forming a substrate for the coating;
wherein the substrate material is aluminum, or made of an alloy comprising aluminum, or made of a material comprising aluminum.

3. The temperature-sensitive housing (10) according to claim 1 or 2,
wherein the coating comprises an insulating layer (IL) made of an electrically insulating material;
wherein the insulating layer (IL) is arranged on the substrate material.

4. The temperature-sensitive housing (10) according to claim 3, wherein the insulating layer (IL) is an aluminum oxide layer.

5. The temperature-sensitive housing (10) according to claim 3 or 4,
wherein the insulating layer (IL) is aluminum oxide or comprises aluminum oxide; and
wherein the insulating layer (IL) has a thickness of more than 0.05 µm, for example a thickness of more than 5 µm, preferably a thickness of more than 10 µm, more preferably a thickness of more than 50 µm, and most preferably a thickness of more than 100 µm.

6. The temperature-sensitive housing (10) according to any one of claims 1 to 5, wherein the coating comprises a temperature-sensitive layer (TL), the temperature-sensitive layer being made of the temperature-sensitive material.

7. The temperature-sensitive housing according to any one of claims 3 to 5 or, as far as depending on claim 3, according to claim 6, wherein the temperature-sensitive layer (TL) directly contacts the insulating layer (IL).

8. The temperature-sensitive housing (10) according to claim 6 to 7, wherein the temperature-sensitive layer (TL) is made of a material comprising TiOₓ/Cr₂O₃, preferably TiO₂/Cr₂O₃ .

9. A battery module comprising:
at least one battery cell (1),
wherein at least one of the battery cells (1) comprises a temperature-sensitive housing (10) according to any one of claims 1 to 8.

10. The battery module according to claim 9, further comprising:
one or more means (30, 30a, 30b, 30c, 30d) for measuring an electrical resistance;
one or more electric circuits, each of the circuits having a first measurement terminal and a second measurement terminal;
wherein at least some of the temperature-sensitive housings (10) are integrated into at least one of the electric circuits; and
wherein each of the means (30, 30a, 30b, 30c, 30d) is adapted to measure the electrical resistance between the first measurement terminal and the second measurement terminal of at least one of the electric circuits.

11. A battery system comprising:
at least one battery module according to claim 9 or 10; and
an evaluation unit (40) configured for:
receiving a signal from each of the means (30, 30a, 30b, 30c, 30d) for measuring an electrical resistance, the signal(s) indicating a resistance measured by the respective means for measuring an electrical resistance;
detecting a deviance of each of the signals received from a means (30, 30a, 30b, 30c, 30d) for measuring an electrical resistance from a predefined setpoint value assigned to the respective means (30, 30a, 30b, 30c, 30d) for measuring an electrical resistance; and
generating an alert signal upon detecting a deviance with an absolute value exceeding a predefined threshold.

12. A vehicle comprising at least one temperature-sensitive housing (10) according to any one of claims 1 to 8, or at least one battery module according to claim 9 or 10, or at least one battery system according to claim 11.
